(19) Europäisches Patentamt / European Patent Office / Office européen des brevets

(11) **EP 2 978 029 A1**

(12) **EUROPEAN PATENT APPLICATION**
published in accordance with Art. 153(4) EPC

(43) Date of publication:
**27.01.2016 Bulletin 2016/04**

(21) Application number: **14769025.9**

(22) Date of filing: **17.03.2014**

(51) Int Cl.:
*H01L 31/0749* (2012.01)   *B21B 1/40* (2006.01)
*B21B 3/02* (2006.01)   *B21B 45/00* (2006.01)

(86) International application number:
**PCT/JP2014/001520**

(87) International publication number:
**WO 2014/148035 (25.09.2014 Gazette 2014/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **21.03.2013 JP 2013057894**

(71) Applicant: **JFE Steel Corporation
Tokyo 100-0011 (JP)**

(72) Inventors:
• **YANO, Takayoshi
Tokyo 100-0011 (JP)**
• **ISHIKAWA, Shin
Tokyo 100-0011 (JP)**
• **YAMAGUCHI, Yasuhiro
Tokyo 100-0011 (JP)**
• **ARIZONO, Tomoyuki
Tokyo 100-0011 (JP)**

(74) Representative: **Hoffmann Eitle
Patent- und Rechtsanwälte PartmbB
Arabellastraße 30
81925 München (DE)**

(54) **FERRITIC STAINLESS STEEL FOIL FOR SOLAR CELL SUBSTRATES**

(57)    Provided is a ferritic stainless steel foil for a solar cell substrate excellent in terms of threading performance with which it is possible to maintain sufficient hardness to suppress occurrence of, for example, buckling during threading when a solar cell is manufactured using a roll-to-roll method. The ferritic stainless steel foil for a solar cell substrate has a chemical composition containing, by mass%, Cr: 14% or more and 24% or less and Nb: 0.1% or more and 0.6% or less, and optionally further containing Mo: 2.0% or less, a Vickers hardness of Hv250 or more and Hv450 or less, and a Vickers hardness of Hv250 or more and Hv450 or less after the substrate has undergone an optical absorber layer growth process in which the substrate is held in a temperature range of 450°C or higher and 650°C or lower for a duration of 1 minute or more.

**Description**

[Technical Field]

The present invention relates to a ferritic stainless steel foil for a solar cell substrate. In particular, the present invention relates to a ferritic stainless steel foil for a solar cell substrate excellent in terms of threading performance which can maintain sufficient hardness to suppress occurrence of, for example, buckling during threading in a process for manufacturing a solar cell using a roll-to-roll method.

[Background Art]

Nowadays, a system for power supply utilizing solar light as a new energy resource is receiving an attention. A crystal Si solar cell having a constituent layer composed of single crystal Si or multi-crystal Si has been put into practice, and such a solar cell plays an important role as a solar photovoltaic system for power supply. However, a process for manufacturing a bulk crystal is necessary in order to manufacture a crystal Si solar cell. Therefore, since it is necessary to use a large amount of raw material, since crystal growth takes a long time, and since the manufacturing process is complex and needs a lot of energy, a manufacturing cost of a crystal Si solar cell is very high.

Against such a background, a solar cell using a highly decreased amount of Si such as a thin film Si solar cell, a solar cell using no Si such as a compound film solar cell, an organic film solar cell, and a dye sensitized solar cell, and a new solar cell such as a quantum dot solar cell have been actively developed and have started to be put into practice. Any of these solar cells is a thin film solar cell which is manufactured by forming a film of amorphous Si or composite semiconductor on a substrate in order to form an optical absorber layer of a thin-film type. Therefore, the manufacturing processes of these solar cells are simpler than that of a crystal Si solar cell, and it is possible to decrease the manufacturing time. In addition, since the thickness of the optical absorber layer is several tens of nm to several $\mu$m, the amounts of raw material used for these solar cells can be significantly decreased compared with those for a crystal Si solar cell.

For the reasons described above, a thin film solar cell is highly anticipated as a next-generation solar cell because of its low manufacturing cost and high mass productivity. In particular, a CIGS (copper indium gallium diselenide) solar cell, which is a compound film solar cell using an optical absorber layer composed of $Cu(In_{1-X}Ga_X)Se_2$ (hereinafter, also abbreviated as CIGS), is receiving a lot of attention because of its photoelectric conversion efficiency higher than that of other thin film solar cells and its low manufacturing cost.

As the substrate of a thin film solar cell, a glass plate such as a soda-lime glass plate, a stainless steel foil, or a plastics film such as a polyimide film is mainly used. Among these materials, since a glass plate cannot be used in a roll-to-roll method, in which the material is continuously treated in the coiled state, because of the lack of flexibility, a glass plate has a disadvantage for mass production or cost reduction. Since a plastics film is poor in terms of heat-resisting property, it has a disadvantage in that it is necessary to lower the upper limit of the treatment temperature in a process for manufacturing a solar cell.

In contrast, since a stainless steel foil is excellent in terms of flexibility and heat-resisting property, it can be used in a roll-to-roll method, which has an advantage for mass production and cost reduction. Since a stainless steel foil has excellent heat-resisting property compared with a plastics film, it is possible to increase the productivity of a solar cell and to manufacture a thin film solar cell, which is light and flexible.

Since a stainless steel foil has excellent flexibility, it is possible to fit a thin film solar cell having a substrate composed of a stainless steel foil to a curved surface. Therefore, it is expected that the application of a solar cell can be further expanded as a so-called flexible solar cell. Among stainless steels, in particular, since ferritic stainless steel has a coefficient of linear thermal expansion almost the same as that of CIGS, consideration is actively being given to using this as the material of the substrate of a thin film solar cell.

A thin film solar cell is manufactured, for example, by forming a back contact layer composed of a Mo layer, an optical absorber layer, a buffer layer, and a transparent contact layer in this order on a substrate. In addition, there is a case where an insulating layer is formed between the substrate and the back contact layer.

In the case where a stainless steel foil is used as the substrate described above, it is possible to use a roll-to-roll method, which has an advantage for mass production, when, for example, an optical absorber layer is formed on the substrate.

In a roll-to-roll method, a roll from which a coiled substrate (stainless steel foil) is released and a roll on which the substrate is rewound are used. Moreover, a thin film forming apparatus for a back contact layer, a thin film forming apparatus for an optical absorber layer, and the like are placed between the two rolls. A back contact layer, an optical absorber layer, a buffer layer, and a transparent contact layer are formed in this order on the substrate which is transported from the releasing roll, and then, the substrate is rewound by the rewinding roll. Therefore, by using a roll-to-roll method, since a large number of solar cells can be continuously manufactured, it is possible to realize mass production and cost reduction of solar cells.

Here, a stainless steel foil used for the substrate of a solar cell has a very thin thickness of 20 to 300 $\mu$m. Therefore, in the case where the strength (hardness) is insufficient, since buckling of the stainless steel foil occurs during threading in a process using a roll-to-roll method, wrinkles, a break, and drawing tend to occur. As above, in the case where, for example, wrinkles occur on the substrate during threading in a continuous process such as one using a roll-to-roll method, it is not possible to manufacture a solar cell or a solar cell having deteriorated photoelectric conversion efficiency is manufactured. Therefore, it is important that a stainless steel foil used as the material of the substrate of a solar cell have sufficient strength (hardness) to prevent the buckling described above so that the foil has satisfactory threading performance in a continuous process such as one using a roll-to-roll method.

Regarding the threading performance of a stainless steel foil (substrate) when a solar cell is manufactured by a continuous process using a roll-to-roll method, Patent Literature 1 proposes a technique in which the tensile strength in a direction at a right angle to the rolling direction of a stainless steel foil is controlled to be 930 MPa or more by performing cold rolling on a stainless steel material with a rolling reduction of 50% or more and by further performing a heat treatment as needed in an inert gas atmosphere having a temperature of 400°C to 700°C in order to obtain a stainless steel foil. Also, it is said that, by using the technique according to Patent Literature 1, in a continuous process using a roll-to-roll method, it is possible to obtain a stainless steel foil for a solar cell substrate with which buckling is less likely to occur.

[Citation List]

[Patent Literature]

PTL 1: Japanese Unexamined Patent Application Publication No. 2012-138571 (International Publication No. WO2012/077827)

[Summary of Invention]

[Technical Problem]

By using the technique proposed in Patent Literature 1, it is possible to improve threading performance by suppressing buckling of a stainless steel foil (substrate) to some extent, in a continuous process using a roll-to-roll method.
However, in the case of the technique according to Patent Literature 1, no consideration is given to the threading performance of a stainless steel foil (substrate) which has undergone an optical absorber layer growth process.
The temperature of a substrate when an optical absorber layer is formed on the substrate after a back contact layer has been formed depends on the kinds of the constituent materials of the optical absorber layer. For example, when the optical absorber layer (CIGS layer) of a CIGS-based compound film solar cell is formed, generally, the substrate undergoes a high-temperature process of 450°C to 650°C. Therefore, even in the case where a stainless steel foil having a specified strength (hardness) is used as a substrate, since the substrate (stainless steel foil) is softened in an optical absorber layer growth process, buckling of the substrate occurs in the following manufacturing process, which results in a problem in that, for example, wrinkles, a break, or drawing tends to occur.
For the reasons described above, it is important that a stainless steel foil used as the material of the substrate of a solar cell have a sufficient heat-resisting property to suppress softening caused in an optical absorber layer growth process so that the stainless steel foil is excellent in terms of threading performance even after having undergone an optical absorber layer growth process in a continuous process using a roll-to-roll method. In the case of the technique according to Patent Literature 1, no consideration is given to such a problem.
Therefore, in the case of the technique according to Patent Literature 1, even if a stainless steel foil (substrate) has sufficient threading performance without occurrence of, for example, wrinkles before undergoing an optical absorber layer growth process in a continuous process using a roll-to-roll method, the stainless steel foil (substrate) is softened as a result of the stainless steel foil being heated at a high temperature of 450°C to 650°C in an optical absorber layer growth process. As a result, since it is not possible to prevent, for example, wrinkles from occurring due to buckling of the stainless steel foil (substrate) in the continuous process following the optical absorber layer growth process described above, there is a deterioration in the productivity and photoelectric conversion efficiency of a solar cell.
The present invention has been completed in order to advantageously solve the problems described above, and an object of the present invention is to provide a ferritic stainless steel foil for a solar cell substrate excellent in terms of threading performance with which it is possible to suppress occurrence of, for example, wrinkles due to buckling of the substrate even in a continuous process following an optical absorber layer growth process when a solar cell is manufactured using a roll-to-roll method.

[Solution to Problem]

The present inventors, in order to solve the problems described above, diligently conducted investigations regarding means for maintaining threading performance by suppressing the buckling and waviness of a stainless steel substrate even in a continuous process following a high-temperature process such as an optical absorber layer growth process (film forming treatment) when a solar cell is manufacture using a roll-to-roll method. As a result, the inventors found that whether or not the buckling or waviness of a stainless steel substrate occurs when a solar cell is manufactured using a roll-to-roll method, that is, whether or not satisfactory threading performance is achieved depends strongly on the Vickers hardness of the stainless steel foil which is used as the substrate and that excellent threading performance is achieved in the case where the stainless steel foil has a Vickers hardness of Hv250 or more and Hv450 or less.

Moreover, from the results of further investigations, the present inventors found that, in the case where a stainless steel foil which has undergone a high-temperature process such as an optical absorber layer growth process when a solar cell is manufactured using a roll-to-roll method, specifically, a stainless steel foil which has undergone an optical absorber layer growth process in which the stainless steel foil is held at any temperature selected from a temperature range of 450°C or higher and 650°C or lower for a duration of 1 minute or more, maintains a Vickers hardness of Hv250 or more and Hv450 or less, it is possible to maintain excellent threading performance so that the buckling and waviness of the substrate (stainless steel foil) are less likely to occur even after the substrate has undergone the optical absorber layer growth process.

In addition, the present inventors sought means for giving a stainless steel foil the hardness quality described above, that is, the hardness quality (heat-resisting property) of having a Vickers hardness of Hv250 or more and Hv450 or less and maintaining a Vickers hardness of Hv250 or more and Hv450 or less even after the stainless steel foil has undergone an optical absorber layer growth process in which the stainless steel foil is held in a temperature range of 450°C or higher and 650°C or lower for a duration of 1 minute or more, and as a result, found that it is effective to perform annealing and cold rolling on a ferritic stainless steel sheet containing specified amounts of Cr and Nb and to thereafter perform a heat treatment under specified conditions. In addition, the present inventors found that it is possible to give a stainless steel foil the desired hardness quality described above by specifying the chemical composition of stainless steel and the rolling reduction of cold rolling, by determining a heat treatment temperature for the heat treatment in accordance with the temperature of the substrate in an optical absorber layer growth process when a solar cell is manufactured, and by specifying further conditions of the heat treatment (heating rate up to the heat treatment temperature, holding time at the heat treatment temperature, and cooling rate after being held at the heat treatment temperature).

The present invention has been completed on the basis of the knowledge described above, and the subject matter of the present invention is as follows.

[1] A ferritic stainless steel foil for a solar cell substrate, the steel foil having a chemical composition containing, by mass%, Cr: 14% or more and 24% or less and Nb: 0.1% or more and 0.6% or less, a Vickers hardness of Hv250 or more and Hv450 or less, and a Vickers hardness of Hv250 or more and Hv450 or less after the substrate has undergone an optical absorber layer growth process in which the substrate is held in a temperature range of 450°C or higher and 650°C or lower for a duration of 1 minute or more.

[2] The ferritic stainless steel foil for a solar cell substrate according to item [1], the steel foil having the chemical composition further containing, by mass%, Mo: 2.0% or less in addition to Cr and Nb described above.

[3] The ferritic stainless steel foil for a solar cell substrate according to item [1] or [2], the steel foil being manufactured by performing annealing, by thereafter performing cold rolling with a rolling reduction of 60% or more, and by subsequently performing a heat treatment in an inert gas atmosphere in such a manner that the steel foil is heated up to a heat treatment temperature T(°C) at a heating rate of 10°C/sec. or more and 100°C/sec. or less, that the steel foil is held at the heat treatment temperature T(°C) for a duration of 1 second or more and 60 seconds or less, and that the heated steel foil is cooled at a cooling rate of 5°C/sec. or more and 50°C/sec. or less,

in which the heat treatment temperature T(°C) satisfies relational expressions (1) and (2) below in accordance with the temperature X of a substrate in an optical absorber layer growth process selected from a temperature range of 450°C or higher and 650°C or lower:

when

$$450°C \leq X < 600°C, \ 300°C \leq T \leq 800°C \quad \cdots \ (1),$$

when

$$600°C \leq X \leq 650°C, \quad X-300°C \leq T \leq 800°C \quad \cdots (2).$$

[4] A method for manufacturing a ferritic stainless steel foil for a solar cell substrate, the method including performing annealing on a ferritic stainless steel sheet having a chemical composition containing, by mass%, Cr: 14% or more and 24% or less and Nb: 0.1% or more and 0.6% or less, thereafter performing cold rolling with a rolling reduction of 60% or more, and subsequently performing a heat treatment in an inert gas atmosphere in such a manner that the resultant ferritic stainless steel foil is heated to a heat treatment temperature T(°C) at a heating rate of 10°C/sec. or more and 100°C/sec. or less, that the steel foil is held at the heat treatment temperature T(°C) for a duration of 1 second or more and 60 seconds or less, and that the heated steel foil is cooled at a cooling rate of 5°C/sec. or more and 50°C/sec/ or less,
in which the heat treatment temperature T(°C) satisfies relational expressions (1) and (2) below in accordance with any temperature X selected from a temperature range of 450°C or higher and 650°C or lower:

when

$$450°C \leq X < 600°C, \quad 300°C \leq T \leq 800°C \quad \cdots (1),$$

when

$$600°C \leq X \leq 650°C, \quad X-300°C \leq T \leq 800°C \quad \cdots (2).$$

[5] The method for manufacturing a ferritic stainless steel foil for a solar cell substrate according to item [4], the ferritic stainless steel sheet having the chemical composition further containing, by mass%, Mo: 2.0% or less.

[Advantageous Effects of Invention]

According to the present invention, it is possible to obtain a ferritic stainless steel foil for a solar cell substrate having excellent threading performance with which it is possible to suppress occurrence of, for example, wrinkles due to buckling of the substrate even after the substrate has undergone an optical absorber layer growth process when a solar cell is manufactured using a roll-to-roll method.

[Description of Embodiments]

The ferritic stainless steel foil for a solar cell substrate according to the present invention is characterized as having a chemical composition containing, by mass%, Cr: 14% or more and 24% or less and Nb: 0.1% or more and 0.6% or less, a Vickers hardness of Hv250 or more and Hv450 or less, and a Vickers hardness of Hv250 or more and Hv450 or less after the substrate has undergone an optical absorber layer growth process in which the substrate is held in a temperature range of 450°C or higher and 650°C or lower for a duration of 1 minute or more.

Cr: 14% or more and 24% or less

The ferritic stainless steel foil for a solar cell substrate according to the present invention is a ferritic stainless steel foil containing Cr in an amount of, by mass%, 14% or more and 24% or less.
Cr is a chemical element which is necessary to give a stainless steel foil corrosion resistance. In the case where the Cr content is less than 14% by mass%, it is not possible to achieve sufficient corrosion resistance to enable a solar cell to be used for a long time. Therefore, in the case where such a stainless steel foil is used as a substrate, there is a problem of corrosion of the substrate when the solar cell is used for a long time.
Although, fundamentally, corrosion resistance improves with increasing Cr content, in the case where Nb is added in combination with Cr, a hot-rolled steel sheet, which is used as the material of a stainless steel foil, becomes brittle if the Cr content is more than 24%. Usually, a stainless steel foil is manufactured by performing hot rolling on a slab in order to obtain a hot-rolled steel sheet, by performing pickling and annealing on the hot-rolled steel sheet as needed, and by thereafter performing cold rolling. In the case where a hot-rolled steel sheet which is used as the material of a stainless steel foil is brittle, it is difficult to perform cold rolling. Therefore, the Cr content of the ferritic stainless steel foil described above is set to be 14% or more and 24% or less by mass%, or preferably 14% or more and 20% or less by mass%.

Nb: 0.1% or more and 0.6% or less

Nb is effective for suppressing softening of a stainless steel foil due to an absorber film growth process by increasing the recrystallization temperature. Such an effect is realized in the case where the Nb content is 0.1% or more by mass%. However, in the case where the Nb content is more than 0.6% by mass%, since a hot-rolled steel sheet which is used as the material of a stainless steel foil becomes brittle, it is difficult to perform cold rolling. Therefore, the Nb content of the ferritic stainless steel foil described above is set to be 0.1% or more and 0.6% or less by mass%, or preferably 0.2% or more and 0.5% or less.

The ferritic stainless steel foil described above may further contain Mo: 2.0% or less by mass% in addition to Cr and Nb.

Mo: 2.0% or less

Mo is a chemical element which is effective for increasing the corrosion resistance, in particular, local corrosion resistance of stainless steel and for suppressing softening of a stainless steel foil due to an optical absorber layer growth process. It is preferable that the Mo content be 0.1% or more by mass% in order to realize such an effect. On the other hand, in the case where the Mo content is more than 2.0% by mass%, since there is an increase in the number of surface defects of stainless steel foil, there is a tendency for the production yield of the solar cell to decrease. Therefore, it is preferable that the Mo content of the ferritic stainless steel foil described above be 2.0% or less by mass%, or more preferably 0.1% or more and 1.8% or less.

There is no limitation on the chemical composition of the ferritic stainless steel foil for a solar cell substrate according to the present invention as long as the contents of Cr and Nb, and optionally the content of Mo, are within the ranges described above.

A particularly suitable chemical composition for the ferritic stainless steel foil for a solar cell substrate according to the present invention will be described below. Hereinafter, "%" used when describing a chemical composition represents mass%, unless otherwise noted.

C: 0.12% or less

Since C deteriorates the corrosion resistance of a stainless steel foil by combining with Cr in steel, it is preferable that the C content be as low as possible. However, since there is not a significant deterioration in corrosion resistance in the case where the C content is 0.12% or less, it is preferable that the C content be 0.12% or less, or more preferably 0.04% or less. In addition, in the case of the present invention where Nb is added, it is further more preferable that the C content be 0.02% or less.

Si: 2.5% or less

Si is a chemical element which is used for deoxidation, and such an effect is realized in the case where the Si content is 0.01% or more. However, in the case where the Si content is excessively high, since there is a deterioration in the ductility of a ferritic stainless steel sheet which is used as the material of a foil, there may be a deterioration in manufacturability. Therefore, it is preferable that the Si content be 2.5% or less, or more preferably 1.0% or less.

Mn: 1.0% or less

There is a case where Mn deteriorates the corrosion resistance of a stainless steel foil by combining with S in steel to form MnS. Therefore, it is preferable that the Mn content be 1.0% or less, or more preferably 0.8% or less.

S: 0.030% or less

As described above, S deteriorates the corrosion resistance of a stainless steel foil by combining with Mn to form MnS. Therefore, it is preferable that the S content be 0.030% or less, or more preferably 0.008% or less.

P: 0.050% or less

P deteriorates manufacturability by deteriorating the ductility of a ferritic stainless steel sheet which is used as the material of a foil. Therefore, it is preferable that the P content be as low as possible. However, there is not a significant deterioration in ductility in the case where the P content is 0.050% or less. Therefore, it is preferable that the P content be 0.050% or less, or more preferably 0.040% or less.

Cr: 14% or more and 24% or less

As described above, Cr is a chemical element which is necessary to achieve sufficient corrosion resistance for a stainless steel foil, and the Cr content in the present invention is set to be 14% or more and 24% or less, or preferably 14% or more and 20% or less.

Nb: 0.1% or more and 0.6% or less

As described above, Nb is effective for suppressing softening of a stainless steel foil due to an optical absorber layer growth process by increasing the recrystallization temperature. Such an effect is realized in the case where the Nb content is 0.1% or more. However, in the case where the Nb content is more than 0.6%, since a hot-rolled steel sheet which is used as the material of a stainless steel foil becomes brittle, it is difficult to perform cold rolling. Therefore, the Nb content is set to be 0.1% or more and 0.6% or less, or preferably 0.2% or more and 0.5% or less.

N: 0.06% or less

N deteriorates the corrosion resistance of a stainless steel foil by combining with Cr in steel. Therefore, it is preferable that the N content be as low as possible. However, there is not a significant deterioration in corrosion resistance in the case where the N content is 0.06% or less. Therefore, it is preferable that the N content be 0.06% or less, or more preferably 0.02% or less.

Although the chemical composition described above is the particularly suitable basic chemical composition of the ferritic stainless steel foil for a solar cell substrate according to the present invention, the following chemical elements may be added as needed in addition to the basic chemical composition described above in the present invention.

Mo: 2.0% or less

As described above, Mo is a chemical element which is effective for increasing the corrosion resistance, in particular, the local corrosion resistance of stainless steel foil and for suppressing softening of a stainless steel foil due to an optical absorber layer growth process. It is preferable that the Mo content be 0.1% or more in order to realize such an effect. On the other hand, in the case where the Mo content is more than 2.0%, since there is an increase in the number of surface defects of stainless steel foil, there is a tendency for the production yield of a solar cell to decrease. Therefore, it is preferable that the Mo content be 2.0% or less, or more preferably 0.1% or more and 1.8% or less.

Al: 0.20% or less

Al is a chemical element which is used for deoxidation, and such an effect is realized in the case where the Al content is 0.001% or more. However, in the case where the Al content is more than 0.20%, since surface defects tend to occur in a stainless steel foil, there is a case where there is a deterioration in the photoelectric conversion efficiency of a solar cell. Therefore, in the case where Al is added, it is preferable that the Al content be 0.20% or less, or more preferably 0.10% or less.

At least one selected from Ti and Zr: 0.40% or less in total

Ti and Zr are chemical elements which are effective for increasing the corrosion resistance of a stainless steel foil by fixing C and N in steel in the form of carbides, nitrides, and carbonitrides. In order to sufficiently realize such an effect, it is preferable that these chemical elements be added separately or in combination in an amount of 0.10% or more in total. However, in the case where the total content is more than 0.40%, there is concern that there may be a deterioration in the photoelectric conversion efficiency of a solar cell due to the generation of surface defects in a stainless steel foil. Therefore, in the case where these chemical elements are added separately or in combination, it is preferable that the total content be limited to 0.40% or less.

In addition to the chemical elements described above, one or more of Ni, Cu, V, and W may be added in an amount of 1.0% or less each in order to improve corrosion resistance. Moreover, one or more of Ca, Mg, rare-earth metals (it also refers to REM), and B may be added in an amount of 0.1% or less each in order to improve hot workability, cold workability, and surface quality.

The remainder of the chemical composition consists of Fe and inevitable impurities. Among the inevitable impurities, it is preferable that the content of O (oxygen) be 0.02% or less.

Vickers hardness: Hv250 or more and Hv450 or less

In the case where the Vickers hardness of a stainless steel foil is less than Hv250, since buckling of the stainless steel foil tends to occur when a solar cell is manufactured using a roll-to-roll method, wrinkles, a break, and drawing tend to occur. Therefore, the Vickers hardness of the ferritic stainless steel foil for a solar cell substrate according to the present invention is set to be Hv250 or more, or preferably Hv270 or more. In the case where the hardness is excessively high, waviness tends to occur, which leads to a problem in that threading performance is deteriorated. Therefore, the Vickers hardness is set to be Hv450 or less, or preferably Hv410 or less.

Vickers hardness after having undergone certain optical absorber layer growth process: Hv250 or more and Hv450 or less

In the case where a solar cell is manufactured using a roll-to-roll method, a substrate is usually heated at a temperature of 450°C to 650°C in an optical absorber layer growth process. In the case where the substrate is softened to Vickers hardness less than Hv250 due to such heating, buckling of the substrate tends to occur in the following processes. Then, there is a deterioration in the productivity and photoelectric conversion efficiency of a solar cell due to buckling of the substrate. On the other hand, in the case where the hardness is excessively high, waviness tends to occur, which leads to a problem in that threading performance is deteriorated.

Therefore, the ferritic stainless steel foil for a solar cell substrate according to the present invention has the hardness quality (heat-resisting property) of having a Vickers hardness of Hv250 or more and Hv450 or less, or preferably Hv270 or more and Hv410 or less, after having undergone a certain optical absorber layer growth process.

As described above, the ferritic stainless steel foil for a solar cell substrate according to the present invention maintains a Vickers hardness of Hv250 or more and Hv450 or less even after having undergone an optical absorber layer growth process in which the stainless steel foil is held in a temperature range of 450°C or higher and 650°C or lower for a duration of 1 minute or more. Therefore, in the case where the ferritic stainless steel foil for a solar cell substrate according to the present invention is used as a substrate when a solar cell is manufactured using a roll-to-roll method, since it is possible to suppress the buckling and waviness of the substrate even after having undergone an optical absorber layer growth process, it is possible to provide a solar cell with which productivity and photoelectric conversion efficiency are satisfactory.

Subsequently, a preferable method for manufacturing the ferritic stainless steel foil for a solar cell substrate according to the present invention will be described.

The ferritic stainless steel foil for a solar cell substrate according to the present invention can be manufactured by performing annealing on a steel sheet which is used as the material of the foil, by thereafter performing cold rolling, and by subsequently performing a heat treatment in an inert gas atmosphere.

In addition, a ferritic stainless steel sheet having a chemical composition containing, by mass%, Cr: 14% or more and 24% or less and Nb: 0.1% or more and 0.6% or less is used as the material of the foil of the steel sheet, the cold rolling is performed with a rolling reduction of 60% or more, and the heat treatment is performed in such a manner that the steel foil is heated to a heat treatment temperature T(°C) at a heating rate of 10°C/sec. or more and 100°C/sec. or less, that the steel foil is held at the heat treatment temperature T(°C) for a duration of 1 second or more and 60 seconds or less, and that the heated steel foil is cooled at a cooling rate of 5°C/sec. or more and 50°C/sec. or less. In addition, a ferritic stainless steel sheet having the chemical composition further containing, by mass%, Mo: 2.0% or less in addition to Cr: 14% or more and 24% or less and Nb: 0.1% or more and 0.6% or less may also be used as the material of the foil of the steel sheet.

There is no limitation on what kind of ferritic stainless steel sheet is used as the material of the foil as long as the steel sheet is a ferritic stainless steel sheet having a chemical composition containing, by mass%, Cr: 14% or more and 24% or less and Nb: 0.1% or more and 0.6% or less, and optionally further containing Mo: 2.0% or less. That is, as long as the contents of Cr and Nb, and optionally the content of Mo, are within the specified condition described above, any kind of ferritic stainless steel sheet may be used as the material of the foil. As long as the contents of Cr and Nb, and optionally the content of Mo, are within the specified condition described above, there is no particular limitation on the chemical composition of a ferritic stainless steel sheet that is used as the material of the foil and that may be selected in accordance with the chemical composition of the target ferritic stainless steel foil for a solar cell substrate.

There is no particular limitation on, for example, what method is used for manufacturing a ferritic stainless steel sheet which is used as the material of the foil, and the stainless steel sheet may be manufactured using a conventionally well-known method. For example, a ferritic stainless steel sheet which is used as the material of a foil may be manufactured by performing hot rolling on a slab which has been cast using a well-known casting method such as a continuous casting method, an ingot casting-slabbing method, and a thin-slab continuous casting method in order to obtain a hot-rolled steel sheet, by performing pickling and annealing on the hot-rolled steel sheet as needed, and by thereafter performing cold rolling.

By performing annealing on the ferritic stainless steel sheet which is used as the material of the foil obtained as described above, and by thereafter performing cold rolling, a stainless steel foil is obtained. There is no particular limitation on what condition is used for the annealing described above, and, for example, bright annealing, which is a condition commonly used for a ferritic stainless steel sheet, may be performed, and further, pickling may be performed after the annealing has been performed.

Rolling reduction of cold rolling: 60% or more

In the case where the rolling reduction of cold rolling which is performed following the annealing described above (the rolling reduction of the cold rolling which is performed on the ferritic stainless steel sheet which is used as the material of a foil) is less than 60%, since there is insufficient work hardening, there is concern that there may be insufficient strength (hardness) for a ferritic stainless steel foil for a solar cell substrate finally obtained. In the case of such a foil having insufficient strength (hardness), since it is difficult to suppress occurrence of buckling when a solar cell is manufactured using a roll-to-roll method, stable threading performance cannot be achieved.

Therefore, it is preferable that the rolling reduction of cold rolling be 60% or more, or more preferably 80% or more. However, in the case where the rolling reduction of cold rolling is excessively high, since there is an excessive increase in residual strain by machining, there is an insufficient decrease in the residual strain by machining even if a heat treatment is performed, which results in concern that the foil may have Vickers hardness more than Hv450. Therefore, it is preferable that the rolling reduction be 95% or less.

Here, it is preferable that the thickness of a stainless foil after cold rolling has been performed be 20 μm or more and 300 μm or less, more preferably 20 μm or more and 120 μm or less, or further more preferably 30 μm or more and 80 μm or less.

A ferritic stainless steel foil for a solar cell substrate is obtained by performing a specified heat treatment on the stainless steel foil having been subjected to cold rolling which has been obtained as described above. This heat treatment is very important for following process es of manufacturing a ferritic stainless steel foil for a solar cell substrate excellent in terms of threading performance by giving the stainless steel foil which has been subjected to cold rolling sufficient heat-resisting property to suppress softening due to an optical absorber layer growth process.

After cold rolling has been performed on the ferritic stainless steel sheet which is used as the material of a foil with a rolling reduction of 60% or more, a large amount of working strain is accumulated in the stainless steel foil. In the case where such a stainless steel foil which has been subjected to cold rolling and in which a large amount of working strain is accumulated is used as a solar cell substrate, the substrate is softened when the working strain is released due to the substrate being heated at a high temperature in an optical absorber layer growth process.

Therefore, a ferritic stainless steel foil for a solar cell substrate is obtained by performing a heat treatment on the stainless steel foil which has been subjected to cold rolling in order to decrease the working strain to an appropriate amount. By using such a stainless steel foil in which residual strain by machining has been appropriately decreased in advance as a solar cell substrate, it is possible in an optical absorber layer growth process to effectively suppress softening of the substrate due to the release of working strain. By leaving an appropriate amount of working strain, since it is possible to obtain a stainless steel foil having sufficient strength (hardness) to prevent buckling, there is an improvement in threading performance in a continuous process such as one using a roll-to-roll method.

It is preferable that the heat treatment described above be performed using, for example, a continuous annealing furnace.

It is preferable that the heat treatment described above is performed in an inert gas atmosphere in order to suppress the oxidation of the surface layer of a stainless steel foil. There is no particular limitation on what kind of inert gas is used, and examples of the inert gas include reducing gases and inert gases such as nitrogen gas, hydrogen gas, argon gas, decomposed ammonia gas (gas mixture containing 75 vol% of hydrogen and 25 vol% of nitrogen), and HN gas (gas mixture containing 5 vol% of hydrogen and 95 vol% of nitrogen). It is preferable that the dewpoint of these gases be -30°C or lower.

Here, it is necessary to optimize heat treatment conditions in order to obtain a ferritic stainless steel foil for a solar cell substrate excellent in terms of threading performance after having undergone an optical absorber layer growth process by giving a stainless steel foil which has been subjected to cold rolling sufficient heat-resisting property (that is, the quality of being softened only a little due to an optical absorber layer growth process). It is preferable that the heat treatment conditions (heat treatment temperature T, heating rate up to the heat treatment temperature T, holding time at the heat treatment temperature T, and cooling rate after being held at the heat treatment temperature T) be specified as follows.

Heat treatment temperature T

As described above, this heat treatment is performed in order to remove working strain which has been accumulated in a stainless steel foil in advance so that a phenomenon, in which an excessive amount of working strain in a substrate is released in an optical absorber layer growth process, is suppressed.

The temperature of a substrate in an optical absorber layer growth process depends on the kind of a material forming the optical absorber layer, and, for example, in the case where the optical absorber layer (CIGS layer) of a CIGS compound film solar cell is formed, the temperature of the substrate is generally selected from a temperature range of 450°C to 650°C. Therefore, by representing this temperature of the substrate in an optical absorber layer growth process by X, the heat treatment temperature T is determined based on X. Specifically, the heat treatment temperature T is determined so that the heat treatment temperature T(°C) satisfies relational expressions (1) and (2) below.
when

$$450°C \leq X < 600°C, \quad 300°C \leq T \leq 800°C \quad \cdots (1),$$

when

$$600°C \leq X \leq 650°C, \quad X-300°C \leq T \leq 800°C \quad \cdots (2).$$

In the case where the heat treatment temperature T is lower than X-300°C or lower than 300°C, since there is a case where there is an insufficient effect of removing working strain which has been accumulated in a cold rolling process, there is concern that, in the case where the stainless steel foil which has been subjected to the heat treatment is used as a solar cell substrate, the substrate may be softened in an optical absorber layer growth process. On the other hand, in the case where the heat treatment temperature T is higher than 800°C, since there is an excessive decrease in working strain, buckling of the substrate tends to occur in a solar cell manufacturing process, which results in a deteriorate in the productivity and photoelectric conversion efficiency of the solar cell.

Holding time at the heat treatment temperature T: 1 second or more and 60 seconds or less, more preferably 1 second or more and 30 seconds or less

In the case where the holding time at the heat treatment temperature T described above is less than 1 second, there is a case where there is an insufficient effect of decreasing working strain, which has been accumulated in a cold rolling, to an appropriate amount. On the other hand, in the case where the holding time at the heat treatment temperature T described above is more than 60 seconds, since the effect of removing working strain becomes saturated, there is not a further increase in the effect of removing working strain, which results only in a deteriorate in productivity. Therefore, it is preferable that the holding time at the heat treatment temperature T described above be 1 second or more and 60 seconds or less. Here, since there is a variation in the heat treatment temperature T in the practical operation of a heat treatment furnace, the holding time may be defined as a time for which the stainless steel foil is held in a temperature range of the heat treatment temperature T ± 20°C. It is more preferable that the holding time be 1 second or more and 30 seconds or less.

Heating rate up to the heat treatment temperature T: 10°C/sec. or more and 100°C/sec. or less

In the case where the heating rate at which a stainless steel foil which has been subjected to cold rolling (that is, a stainless steel foil at room temperature) is heated up to the heat treatment temperature T is less than 10°C/sec, since temper color (thin oxide film) tends to occur on the surface of the stainless steel foil, there is a case where the stainless steel foil cannot be used as a solar cell substrate. In addition, in the case where the heating rate is more than 100°C/sec, since there is a non-uniform temperature distribution, there is concern that deformations such as asperity (irregularity; center buckle; and edge wave, in which edges are elongated in a wavy shape) may occur in the foil. Therefore, it is preferable that the heating rate be 10°C/sec. or more and 100°C/sec. or less, or more preferably 20°C/sec. or more and 70°C/sec. or less.

Cooling rate after being held at the heat treatment temperature T: 5°C/sec. or more and 50°C/sec. or less

In the case the cooling rate is less than 5°C/sec. when the stainless steel foil is cooled to a temperature range of 300°C or lower after the foil being held at the heat treatment temperature T, since temper color tends to occur on the surface of the stainless steel foil, there is a case where the stainless steel foil cannot be used as a solar cell substrate. On the other hand, in the case where the cooling rate is more than 50°C/sec, since there is concern that there may be deterioration in the shape of the stainless steel foil due to the deformation of the foil, it is difficult to achieve dimensional precision required for a solar cell substrate. Therefore, it is preferable that the cooling rate be 5°C/sec. or more and 50°C/sec. or less, or more preferably 15°C/sec. or more and 35°C/sec. or less.

By performing the heat treatment describe above, working strain of the stainless steel foil which has been generated as a result of performing cold rolling is appropriately decreased. As a result, it is possible to obtain a ferritic stainless steel foil for a solar cell substrate having a Vickers hardness of Hv250 or more and Hv450 or less and a Vickers hardness of Hv 250 or more and Hv450 or less after having undergone an optical absorber layer growth process, in which the substrate is held at a temperature range of 450°C or higher and 650°C or lower for a duration of 1 minute or more.

In the case where a solar cell is manufactured using the ferritic stainless steel foil for a solar cell substrate according to the present invention, it is preferable that the solar cell be manufacture using the following methods.

A thin film solar cell is usually manufactured, for example, by forming a back contact layer composed of a Mo layer, an optical absorber layer, a buffer layer, and transparent contact layer in this order on a substrate, and by further forming a grid electrode on the surface of the transparent contact layer. In addition, an insulating layer may be formed between the substrate and the back contact layer. By forming the insulating layer, an integrated solar cell structure can be obtained. It is preferable to use a roll-to-roll method, which is useful for mass production, when (the insulating layer,) the back contact layer, the optical absorber layer, the buffer layer, and the transparent contact layer are formed in this order on the substrate.

There is no particular limitation on what method is used for forming a back contact layer, and for example, any of a PVD method (physical vapor deposition method), a CVD method (chemical vapor deposition method), a sputtering method, and so forth may be used. Examples of a material forming a back contact layer include Mo. After having formed the back contact layer, an optical absorber layer is formed over the back contact layer.

It is very important to control the temperature of the substrate when an optical absorber layer is formed.

For example, in the case of a CIGS solar cell, since high photoelectric conversion efficiency can be achieved when the optical absorber layer (CIGS layer) is formed at a high temperature, the substrate temperature is usually selected in a temperature range of 450°C to 650°C when an optical absorber layer (CIGS layer) is formed. On the other hand, in the case where the substrate is heated to a high temperature range of 450°C to 650°C when the optical absorber layer is formed in a continuous process using a roll-to-roll method, since there is a decrease in the hardness of the substrate, there is concern that the buckling of the substrate may occur in the continuous processes following an optical absorber layer growth process. In the case where buckling of the substrate occurs as described above, it is not possible to prevent the productivity and photoelectric conversion efficiency of a solar cell from decreasing.

However, in the case of the ferritic stainless steel foil for a solar cell substrate according to the present invention, it is possible to maintain the hardness, that is, a Vickers hardness of Hv250 or more and Hv450 or less, which is necessary to suppress the buckling and waviness of the substrate even after the substrate has undergone an optical absorber layer growth process in which the substrate is held at a temperature range of 450°C or higher and 650°C or lower for a duration of 1 minute or more.

There is no particular limitation on what method is used for forming an optical absorber layer as long as the substrate temperature is selected in a temperature range of 450°C or higher and 650°C or lower when the layer is formed, the layer may be formed using, for example, a PVD method such as an evaporation method and a sputtering method, a CVD method, an electrodeposition method, or a spin coating method.

As described above, since there is a variation in the substrate temperature in the practical operation of a layer forming apparatus, it is acceptable that X represent a temperature range of the substrate temperature $\pm$ 20°C when the layer is formed.

After an optical absorber layer has been formed, a buffer layer and a transparent contact layer are formed in this order over the optical absorber layer. Examples of a material composing a buffer layer include CdS-based materials, InS-based materials, and Zn(S, O, OH). In addition, examples of a material forming a transparent contact layer include ZnO. There is no particular limitation on what means is used for forming a buffer layer and a transparent contact layer, and a CBD method (chemical bath deposition method), an evaporation method, a sputtering method, and a CVD method may be used.

[EXAMPLES]

A solar cell substrate is required to have an excellent heat-resisting property with which it is possible to suppress softening of the substrate due to an optical absorber layer growth process when a solar cell is manufactured using a roll-to-roll method and required to have excellent threading performance with which it is possible to suppress occurrence of the wrinkles and the like, and waviness of the substrate due to buckling of the substrate even after the optical absorber layer growth process. This is because there is a deteriorate in the productivity and photoelectric conversion efficiency of a solar cell in the case where, for example, the wrinkles of the substrate occur during threading in a continuous process such as one using a roll-to-roll method. Also, this is because there is a problem of a deteriorate in manufacturability due to a deteriorate in threading performance in the case where waviness occurs.

In view of the required properties described above, the samples of a stainless steel foil for a solar cell substrate were prepared, and various tests were conducted in order to evaluate the properties described above. The methods for preparing the samples, the various testing methods, and the evaluation method will be described hereafter.

(1) Method for preparing samples

By performing bright annealing on the stainless steel sheets having the chemical compositions showed in Table 1, and by thereafter performing cold rolling with the rolling reductions showed in Table 2 using a 20-high Sendzimir cold rolling mill (roll diameter: 55 mm), ferritic stainless steel foils having a thickness of 50 μm were obtained.

By degreasing the stainless steel foils having a thickness of 50 μm obtained as described above, and by thereafter performing a heating treatment in an atmosphere of nitrogen gas having a dewpoint of -65°C, the samples of a stainless steel foil for a solar cell substrate were obtained. The heating treatment conditions (the heating treatment temperature, the holding time at the heating treatment temperature, the heating rate up to the heating treatment temperature, and the cooling rate after being held at the heat treatment temperature) are showed in Table 2. Here, in the case of some stainless steel foils (sample Nos. 16 and 17 in Table 2), the samples of a stainless steel foil for a solar cell substrate were prepared without performing the heat treatment.

(2) Method for manufacturing a solar cell using a roll-to-roll method

Using the samples which had been prepared as described in (1) above as substrates, a back electrode composed of a Mo layer (having a thickness of 1 μm) was formed on the substrate in a continuous process using a roll-to-roll method, and then, an optical absorber layer composed of $Cu(In_{1-X}Ga_X)Se_2$ (having a thickness of 2 μm) was formed on the back electrode composed of a Mo layer. The back electrode composed of a Mo layer was formed using a sputtering method. In addition, the optical absorber layer was formed using a multi-source evaporation method. The substrate temperature and the layer forming time (holding time at the substrate temperature) among the layer forming conditions which were used when the optical absorber layer was formed are showed in Table 2.

(3) Hardness test (the evaluation of the Vickers hardness before and after the optical absorber layer growth process)

Using the samples prepared as described in (1) above and the samples after an optical absorber layer had been formed as described in (2) above, a Vickers hardness test was conducted in accordance with JIS Z 2244 (1998) (the tested surface of the sample: cross section in the thickness direction).

(4) Evaluation of threading performance

The threading performance was evaluated by performing a visual test in which the surface of the substrate was observed when threading was performed in the continuous processes before and after the optical absorber layer growth process in order to confirm whether or not wrinkles, a break, or drawing occurred due to buckling. A case where occurrence of wrinkles, a break, or drawing due to buckling was not observed was judged as a case of satisfactory threading performance (O), and a case where occurrence of wrinkles, a break, or drawing due to buckling was observed was judged as a case of unsatisfactory threading performance (x). Also, a case where asperity or edge wave occurred on the surface of the stainless steel foil instead of wrinkles, a break, or drawing or a case where an abnormal contact with the layer forming apparatus occurred due to a deterioration in flatness of the base caused by the deformation described above was judged as a case of unsatisfactory threading performance (x).

The obtained results are showed in Table 2.

[Table 1]

| Steel | Chemical Composition (mass%) | | | | | | | | | |
|-------|------|------|------|-------|-------|-------|------|------|------|-------|
|       | C    | Si   | Mn   | P     | S     | Al    | Cr   | Mo   | Nb   | N     |
| A     | 0.004 | 0.29 | 0.19 | 0.025 | 0.002 | 0.018 | 14.9 | 1.56 | 0.45 | 0.008 |
| B     | 0.012 | 0.28 | 0.45 | 0.026 | 0.003 | 0.002 | 17.6 | -    | 0.43 | 0.014 |

[Table 2]

| Sample No. | Steel | Cold Rolling Reduction (%) | Heat Treatment Condition | | | | Hardness (Hv)*4 | Threading Performance before Optical Absorber Layer Growth | Optical Absorber Layer Growth Condition | | Hardness after Optical Absorber Layer Growth (Hv) | Threading Performance after Optical Absorber Layer Growth | Note |
|---|---|---|---|---|---|---|---|---|---|---|---|---|---|
| | | | Heat Treatment Temperature (°C) | Holding Time (sec.)*1 | Heating Rate (°C/sec.) *2 | Cooling Rate (°C/sec.) *3 | | | Layer Forming Temperature (°C)*5 | Holding Time at Layer Forming Temperature (minute)*6 | | | |
| 1 | A | 85 | 300 | 3.1 | 29 | 18 | 395 | ○ | 450 | 5 | 390 | ○ | Example |
| 2 | | 85 | 400 | 2.7 | 32 | 20 | 387 | ○ | 450 | 5 | 401 | ○ | Example |
| 3 | | 85 | 700 | 2.5 | 44 | 25 | 392 | ○ | 450 | 5 | 398 | ○ | Example |
| 4 | | 85 | 800 | 2.3 | 48 | 29 | 260 | ○ | 450 | 5 | 258 | ○ | Example |
| 5 | | 85 | 300 | 3.1 | 29 | 18 | 395 | ○ | 550 | 5 | 399 | ○ | Example |
| 6 | | 85 | 400 | 2.7 | 32 | 20 | 387 | ○ | 550 | 5 | 406 | ○ | Example |
| 7 | | 80 | 700 | 2.5 | 44 | 25 | 385 | ○ | 550 | 5 | 402 | ○ | Example |
| 8 | | 85 | 700 | 2.5 | 44 | 25 | 392 | ○ | 550 | 5 | 406 | ○ | Example |
| 9 | | 85 | 800 | 2.3 | 48 | 29 | 260 | ○ | 550 | 5 | 271 | ○ | Example |
| 10 | | 85 | 350 | 2.9 | 30 | 19 | 392 | ○ | 650 | 5 | 379 | ○ | Example |
| 11 | | 85 | 400 | 2.7 | 32 | 20 | 387 | ○ | 650 | 30 | 327 | ○ | Example |
| 12 | | 85 | 700 | 2.5 | 44 | 25 | 392 | ○ | 650 | 30 | 315 | ○ | Example |
| 13 | | 85 | 800 | 2.3 | 48 | 29 | 260 | ○ | 650 | 5 | 255 | ○ | Example |
| 14 | B | 85 | 400 | 2.7 | 32 | 20 | 383 | ○ | 550 | 5 | 376 | ○ | Example |
| 15 | | 85 | 700 | 2.5 | 44 | 25 | 379 | ○ | 550 | 5 | 394 | ○ | Example |
| 16 | A | 85 | Undone | - | - | - | 455 | × | - | - | - | - | Comparative Example |
| 17 | B | 85 | Undone | - | - | - | 452 | × | - | - | - | - | Comparative Example |
| 18 | A | 60 | Undone | - | - | - | 305 | ○ | 550 | 30 | 226 | × | Comparative Example |

EP 2 978 029 A1

13

(continued)

| Sample No. | Steel | Cold Rolling Reduction (%) | Heat Treatment Condition | | | | Hardness (Hv)*4 | Threading Performance before Optical Absorber Layer Growth | Optical Absorber Layer Growth Condition | | Hardness after Optical Absorber Layer Growth (Hv) | Threading Performance after Optical Absorber Layer Growth | Note |
| | | | Heat Treatment Temperature (°C) | Holding Time (sec.)*1 | Heating Rate (°C/sec.) *2 | Cooling Rate (°C/sec.) *3 | | | Layer Forming Temperature (°C)*5 | Holding Time at Layer Forming Temperature (minute)*6 | | | |
| 19 | A | 65 | 825 | 15 | 20 | 14 | 243 | × | - | - | - | - | Comparative Example |
| 20 | B | 60 | 275 | 5.5 | 27 | 18 | 315 | ○ | 550 | 30 | 231 | × | Comparative Example |
| 21 | A | 60 | 325 | 5.8 | 26 | 17 | 335 | ○ | 650 | 30 | 240 | × | Comparative Example |

*1) Retention time for which a stainless steel foil is held in a temperature range of the heat treatment temperature ±20°C.
*2) Average heating rate when heating is performed from room temperature (30°C) to the heat treatment temperature.
*3) Average cooling rate when cooling is performed from the heat treatment temperature to the temperature at the exit of the heat treatment furnace.
*4) Hardness of a stainless steel foil before an optical absorber layer is formed.
*5) Temperature of a substrate when an optical absorber layer is formed.
*6) Retention time for which a substrate is held in a temperature range of the layer forming temperature ±20°C.

As Table 2 indicates, the following facts are confirmed.

In the case of the samples of the examples of the present invention (Nos. 1 through 15), the Vickers hardness was Hv250 or more and Hv450 or less before and after an optical absorber layer growth process, and the occurrence of, for example, wrinkles was not observed, which means that satisfactory threading performance was maintained. In contrast, in the case of the samples of the comparative examples (sample Nos. 16 and 17) where a heating treatment was not performed, the Vickers hardness was more than Hv450 before the optical absorber layer is formed, and the occurrence of waviness was observed, which means that threading performance was unsatisfactory. In the case of the samples of the comparative examples (Nos. 18 through 21) where a heat treatment was not performed or where the heat treatment temperature was out of the range according to the present invention, the Vickers hardness was less than Hv250 before or after an optical absorber layer growth process, and the occurrence of wrinkles and the like was observed, which means that threading performance was unsatisfactory.

In the case of the examples described above, using the sample which had been prepared as a substrate, a back electrode was formed using a sputtering method, and an optical absorber layer was formed using a multi-source evaporation method. However, in the present invention, even in the case where a back electrode and an optical absorber layer are formed using methods other than these, the same effects as those which were realized in the examples (of the present invention) described above are realized.

[Industrial Applicability]

According to the present invention, even in the case where a stainless steel foil which is inexpensive and which can be mass-produced is used as a solar cell substrate, it is possible to suppress occurrence of, for example, wrinkles due to buckling of the substrate and it is possible to maintain excellent threading performance even after an optical absorber layer is formed when a solar cell is manufactured using a roll-to-roll method. Therefore, there is a decrease in the manufacturing cost of a solar cell, and an improvement in photoelectric conversion efficiency can be expected, which results in a significant effect in industry.

**Claims**

1. A ferritic stainless steel foil for a solar cell substrate, the steel foil having a chemical composition containing, by mass%, Cr: 14% or more and 24% or less and Nb: 0.1% or more and 0.6% or less, a Vickers hardness of Hv250 or more and Hv450 or less, and a Vickers hardness of Hv250 or more and Hv450 or less after the substrate has undergone an optical absorber layer growth process in which the substrate is held in a temperature range of 450°C or higher and 650°C or lower for a duration of 1 minute or more.

2. The ferritic stainless steel foil for a solar cell substrate according to Claim 1, the steel foil having the chemical composition further containing, by mass%, Mo: 2.0% or less in addition to Cr and Nb described above.

3. The ferritic stainless steel foil for a solar cell substrate according to Claim 1 or 2, the steel foil being manufactured by performing annealing, by thereafter performing cold rolling with a rolling reduction of 60% or more, and by subsequently performing a heat treatment in an inert gas atmosphere in such a manner that the steel foil is heated up to a heat treatment temperature T(°C) at a heating rate of 10°C/sec. or more and 100°C/sec. or less, that the steel foil is held at the heat treatment temperature T(°C) for a duration of 1 second or more and 60 seconds or less, and that the heated steel foil is cooled at a cooling rate of 5°C/sec. or more and 50°C/sec. or less,

wherein the heat treatment temperature T(°C) satisfies relational expressions (1) and (2) below in accordance with the temperature X of a substrate in an optical absorber layer growth process selected from a temperature range of 450°C or higher and 650°C or lower:

when

$$450°C \leq X < 600°C, \ 300°C \leq T \leq 800°C \quad \cdots (1).$$

when

$$600°C \leq X \leq 650°C, \ X-300°C \leq T \leq 800°C \quad \cdots (2).$$

4. A method for manufacturing a ferritic stainless steel foil for a solar cell substrate, the method comprising performing annealing on a ferritic stainless steel sheet having a chemical composition containing, by mass%, Cr: 14% or more and 24% or less and Nb: 0.1% or more and 0.6% or less, thereafter performing cold rolling with a rolling reduction of 60% or more, and subsequently performing a heat treatment in an inert gas atmosphere in such a manner that the resultant ferritic stainless steel foil is heated to a heat treatment temperature T(°C) at a heating rate of 10°C/sec. or more and 100°C/sec. or less, that the steel foil is held at the heat treatment temperature T(°C) for a duration of 1 second or more and 60 seconds or less, and that the heated steel foil is cooled at a cooling rate of 5°C/sec. or more and 50°C/sec. or less,

wherein the heat treatment temperature T(°C) satisfies relational expressions (1) and (2) below in accordance with any temperature X selected from a temperature range of 450°C or higher and 650°C or lower:

when

$$450°C \leq X < 600°C, \quad 300°C \leq T \leq 800°C \quad \cdots (1)$$

when

$$600°C \leq X \leq 650°C, \quad X\text{-}300°C \leq T \leq 800°C \quad \cdots (2).$$

5. The method for manufacturing a ferritic stainless steel foil for a solar cell substrate according to Claim 4, the ferritic stainless steel sheet having the chemical composition further containing, by mass%, Mo: 2.0% or less.

**INTERNATIONAL SEARCH REPORT**

| International application No. |
| --- |
| PCT/JP2014/001520 |

A.  CLASSIFICATION OF SUBJECT MATTER
*H01L31/0749*(2012.01)i, *B21B1/40*(2006.01)i, *B21B3/02*(2006.01)i, *B21B45/00*
(2006.01)i

According to International Patent Classification (IPC) or to both national classification and IPC

B.  FIELDS SEARCHED

Minimum documentation searched (classification system followed by classification symbols)
H01L31/06-078, H01L31/18-20, B21B1/40, B21B3/02, B21B45/00

Documentation searched other than minimum documentation to the extent that such documents are included in the fields searched
   Jitsuyo Shinan Koho          1922-1996   Jitsuyo Shinan Toroku Koho   1996-2014
   Kokai Jitsuyo Shinan Koho    1971-2014   Toroku Jitsuyo Shinan Koho   1994-2014

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>A | WO 2012/077827 A1  (JFE Steel Corp.),<br>14 June 2012 (14.06.2012),<br>pages 3 to 10<br>& JP 2012-138571 A      & CN 103249502 A<br>& TW 201240107 A | 1-3<br>4-5 |
| A | JP 62-134980 A  (Kawasaki Steel Corp.),<br>18 June 1987 (18.06.1987),<br>entire text; all drawings<br>(Family: none) | 1-5 |

☐  Further documents are listed in the continuation of Box C.        ☐  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    27 March, 2014 (27.03.14) | Date of mailing of the international search report<br>    08 April, 2014 (08.04.14) |
| --- | --- |
| Name and mailing address of the ISA/<br>    Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012138571 A

- WO 2012077827 A